Europäisches Patentamt

European Patent Office

Office européen des brevets

(19)

(11) Numéro de publication : **0 498 717 A1**

# (12) DEMANDE DE BREVET EUROPEEN

(21) Numéro de dépôt : **92400287.6**

(22) Date de dépôt : **05.02.92**

(51) Int. Cl.⁵ : **H01L 21/76, H01L 21/32**

(30) Priorité : **07.02.91 FR 9101381**

(43) Date de publication de la demande :
**12.08.92 Bulletin 92/33**

(84) Etats contractants désignés :
**DE FR GB**

(71) Demandeur : **FRANCE TELECOM**
**6 place d'Alleray**
**F-75015 Paris (FR)**

(72) Inventeur : **Straboni, Alain**
**13, rue Stendhal**
**F-38320 Eybens (FR)**
Inventeur : **Barla, Kathy**
**21, rue Turenne**
**F-38000 Grenoble (FR)**
Inventeur : **Vuillermoz, Bernard**
**22 Bd. Maréchal Leclerc**
**F-38000 Grenoble (FR)**

(74) Mandataire : **Fréchède, Michel et al**
**Cabinet Plasseraud 84, rue d'Amsterdam**
**F-75009 Paris (FR)**

(54) **Procédé d'oxydation localisée enterrée d'un substrat de silicium et circuit intégré correspondant.**

(57) L'invention concerne un procédé d'oxydation localisée enterrée d'un substrat de silicium.

Le procédé consiste à effectuer a) sur la surface du substrat (S), par une première nitruration, un scellement par croissance d'une couche de nitrure de silicium formant au moins une couche superficielle, puis à effectuer b) la gravure (G1) d'une tranchée (T) destinée à recevoir l'oxydation localisée enterrée.

Une deuxième nitruration est effectuée c) sur la surface libre de la tranchée (T) afin d'obtenir un scellement sc des parois de la tranchée (T).

Une gravure (G2) est effectuée en d) sur la paroi de fond de la tranchée (T) par gravure, au moins partielle, de la couche de nitrure de silicium obtenue par deuxième nitruration afin de découvrir le matériau du substrat (S).

Une oxydation localisée e) est effectuée pour réaliser l'oxydation enterrée (OE) du substrat dans la tranchée.

Application à la réalisation de circuits intégrés.

FIG.2.

L'invention est relative à un procédé d'oxydation localisée enterrée d'un substrat de silicium et au circuit intégré correspondant.

Dans le domaine technique de la fabrication des circuits intégrés, il est nécessaire d'empêcher l'oxydation du silicium dans les zones actives réservées à la fabrication des dispositifs tels que les transistors. Le procédé le plus utilisé est le procédé LOCOS désignant en langage anglo-saxon "LOCalized Oxidation of Silicon". Le matériau de masquage le plus efficace est le nitrure de silicium $Si_3N_4$. Le matériau est habituellement déposé par dépôt chimique en phase vapeur (C.V.D.). Cependant, un tel dépôt ne peut être effectué directement sur le substrat de silicium en raison des différences des valeurs des coefficients de dilatation de ces matériaux et il est donc nécessaire d'utiliser une couche intermédiaire de dioxyde de silicium $SiO_2$, laquelle sert de couche tampon entre la couche de nitrure de silicium et le substrat de silicium.

Toutefois, l'introduction de cette couche d'oxyde de silicium, produite par oxydation de la surface du substrat, et appelée généralement oxyde piédestal, présente un inconvénient important lorsque les dimensions d'intégration du circuit approchent les valeurs microniques ou submicroniques.

Cette couche, en effet, constitue une voie de pénétration de l'oxyde sous le masque, ce qui provoque le défaut désigné par "bec d'oiseau". Un tel défaut réduit la surface active utilisable ; il constitue une des majeures limitations à l'augmentation de la densité d'intégration.

Différentes solutions ont été proposées. Parmi celles-ci, on peut citer le procédé SILO (Sealed Interface Localised oxidation), lequel consiste à intercaler une couche de nitrure de silicium entre l'oxyde piédestal et le substrat de silicium. La nitruration du silicium peut être effectuée au moyen d'un plasma d'azote et permet normalement d'éviter l'apparition du "bec d'oiseau".

Les procédés LOCOS et SILO précités demeurant des procédés d'oxydation de type semi-enterré, les substrats présentent une différence de niveau entre les surfaces des zones actives et de l'oxyde localisé, une telle différence de niveau étant préjudiciable aux passages des lignes d'interconnexion. En outre, les structures obtenues par la mise en oeuvre de ces procédés présentent des propriétés d'isolement électrique limitées car l'oxyde ne pénètre dans le silicium que sur la moitié de l'épaisseur de l'oxyde.

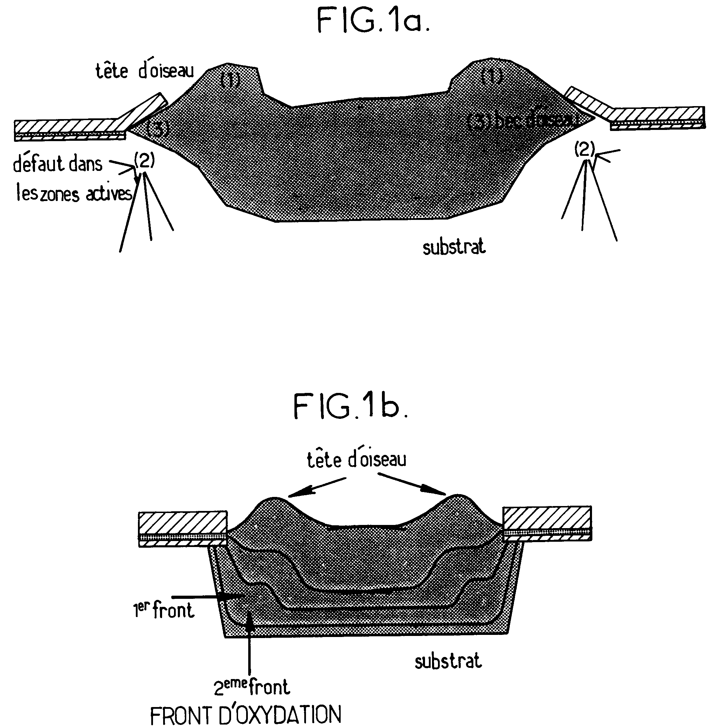

Dans le cas d'un procédé de type LOCOS enterré, d'autres problèmes se manifestent encore. De manière générale, dans ce type de procédé, à partir de l'ouverture de la couche de nitrure sur l'oxyde piédestal, il est pratiqué une gravure du silicium sur une profondeur voisine de la moitié de l'épaisseur de l'oxyde final désiré. Cette tranchée est ensuite oxydée suivant les procédés thermiques classiques. Lorsqu'on effectue l'oxydation des surfaces de silicium situées à l'intérieur de la tranchée, les problèmes ci-après apparaissent, ainsi que représenté en figure 1a). La surface de l'oxyde développe un renflement appelé "tête d'oiseau" (1), lequel dépasse la surface des zones actives du silicium. Un tel renflement constitue un obstacle au passage des conducteurs d'interconnexion, des discontinuités peuvent empêcher le passage du courant. En outre, les fortes contraintes mécaniques sont développées, celles-ci pouvant induire des défauts (2) dans la structure cristalline du substrat, avec apparition de dégradations des qualités de conduction du silicium ou apparition de courants de fuite dans les jonctions. Lors de l'oxydation, il se produit une oxydation latérale comparable à celle mentionnée relativement au procédé LOCOS semi-enterré, ce qui provoque l'apparition du défaut désigné par "bec d'oiseau" (3). Un tel défaut provoque une dégradation de cote par rapport aux dimensions dessinées par photolithographie pouvant atteindre 0,5 µm. Ainsi, les capacités de conduction d'un transistor MOS de largeur 1 µm peuvent-elles être réduites de moitié, en raison de l'existence de ce défaut.

Ainsi qu'on l'a représenté de manière schématique en figure 1b), lorsqu'un oxyde croit par réaction du silicium avec une espèce oxydante, la vapeur d'eau par exemple, le volume occupé par l'oxyde résultant est le double de celui du silicium mis en oeuvre par cette croissance et l'espace libre à l'intérieur de la tranchée est insuffisant pour assurer une expansion correspondante de l'oxyde ainsi formé. Ainsi, un premier et deuxième fronts d'oxydation se rencontrent, ces fronts étant dûs à l'oxydation du fond respectivement de la paroi de la tranchée. Un tel phénomène est la cause du premier et du deuxième problèmes précédemment mentionnés. En effet, dans la zone située en bord de masque, le déplacement de la masse excédentaire d'oxyde s'effectue par fluage de l'oxyde selon un mouvement lent et la vitesse de croissance de l'oxyde, plus rapide, entraîne la création de contraintes de compression dans cette zone. Ces contraintes sont transmises au substrat de silicium, lequel les absorbe en créant des défauts dans sa structure cristalline. En ce qui concerne le troisième problème précédemment cité, la formation du "bec d'oiseau" est due à la diffusion des espèces oxydantes dans l'oxyde piédestal, ce qui provoque l'oxydation de la surface de silicium sous le masque. La présence de ce "bec d'oiseau" dans le LOCOS enterré, comme dans le cas du LOCOS semi-enterré, est une cause supplémentaire à la formation excédentaire d'oxyde en bord de masque et contribue donc à la formation de la "tête d'oiseau".

Parmi les solutions proposées afin de remédier aux inconvénients précités, on peut citer un procédé, connu sous le nom de procédé SWAMI, consistant à déposer une deuxième couche de nitrure de silicium visant à protéger la paroi de l'oxydation. En outre, la couche de nitrure empêche la diffusion des espèce oxydantes dans l'oxyde piédestal.

Toutefois, la mise en oeuvre de ce procédé a montré l'existence d'une densité importante de défauts dans les zones actives, en raison de contraintes développées par l'épaisseur, trop importante, de la deuxième couche de nitrure. Cette couche, déposée par dépôt chimique en phase vapeur, ne peut être inférieure à 10nm. Ce procédé peut être amélioré par interposition d'une couche d'oxyde piédestal entre la deuxième couche de nitrure et la paroi de silicium, cependant cela réduit l'efficacité du marquage ou scellement par la deuxième couche de nitrure, la couche d'oxyde piédestal accentuant la progression de l'oxydation sous le masque. De même, ce défaut de scellement de la paroi existe également en l'absence d'oxyde piédestal car l'oxyde naturel toujours présent sur la paroi de silicium empêche un bon contact entre le nitrure et le silicium et constitue une voie de pénétration des espèces oxydantes. Une autre difficulté de mise en oeuvre de ce procédé réside dans le fait qu'après oxydation localisée, il est nécessaire d'éliminer la partie de la couche de nitrure non oxydée. Les résidus à éliminer, constitués d'un mélange d'oxyde et de nitrure, formant des oxynitrures, sont difficiles à graver sélectivement sans endommager l'oxyde enterré.

Des travaux correspondants ont été décrits plus récemment notamment dans la demande de brevet EP 284 456 dans laquelle un procédé est décrit, des couches de nitrure de silicium étant utilisées pour assurer le scellement de tranchées, ces couches étant réalisées par des couches épaisses déposées par dépôt chimique en phase vapeur. Un tel procédé ne permet cependant pas de sceller convenablement l'interface de la tranchée en raison de la présence de l'oxyde naturel inévitablement présent à la surface du silicium, des couches très minces ne pouvant être déposées selon cette technique. Le problème de l'élimination par gravure des résidus de nitrure qui ne sont pas consommés lors de l'oxydation localisée n'est pas résolu par la mise en oeuvre de ce procédé.

Le procédé d'oxydation localisée enterrée d'un substrat de silicium objet de la présente invention vise à remédier aux inconvénients précités.

Il est remarquable en ce qu'il consiste, successivement, à effectuer sur la surface libre du substrat, par une première nitruration, un scellement par croissance d'une couche de nitrure de silicium formant au moins une couche superficielle, afin d'assurer le scellement de cette surface libre, formant interface horizontale. Suite à une étape de masquage appropriée, une gravure d'une tranchée est effectuée dans le substrat de silicium et la couche de nitrure, cette tranchée étant destinée à recevoir l'oxydation localisée enterrée. Un scellement des parois de la tranchée est effectué par une deuxième nitruration de la surface libre de la tranchée, par croissance d'une deuxième couche de nitrure de silicium. Une gravure, au moins partielle, de la couche de nitrure de silicium obtenue par la deuxième nitruration est effectuée sur la paroi de fond de la tranchée, afin de découvrir le matériau du substrat de silicium. Une oxydation localisée de ce matériau est effectuée pour réaliser l'oxydation enterrée du substrat dans la tranchée.

Le procédé objet de l'invention trouve application à la fabrication des circuits intégrés dans les technologies d'isolement latéral.

Le procédé objet de l'invention sera mieux compris à la lecture de la description et à l'observation des dessins ci-après dans lesquels, outre les figures 1a et 1b relatives à l'art antérieur :

- la figure 2 représente, à titre d'exemple non limitatif, un premier mode de mise en oeuvre du procédé objet de l'invention ;
- la figure 3 représente, à titre d'exemple non limitatif, un deuxième mode de mise en oeuvre du procédé objet de l'invention ;
- les figures 4a et 4b représentent une vue en coupe d'une plaquette de silicium comportant une oxydation localisée complètement ou partiellement enterrée conformément à l'objet de l'invention.
- la figure 5a représente une vue cotée d'un substrat S de silicium soumis au procédé objet de la présente invention et correspondant à l'étape d) de la figure 2,
- la figure 5b représente en coupe, dans le même plan de coupe que celui de la figure 5a, une vue cotée d'un circuit intégré objet de l'invention, comportant une zone d'oxyde enterré réalisée selon le procédé de l'invention.

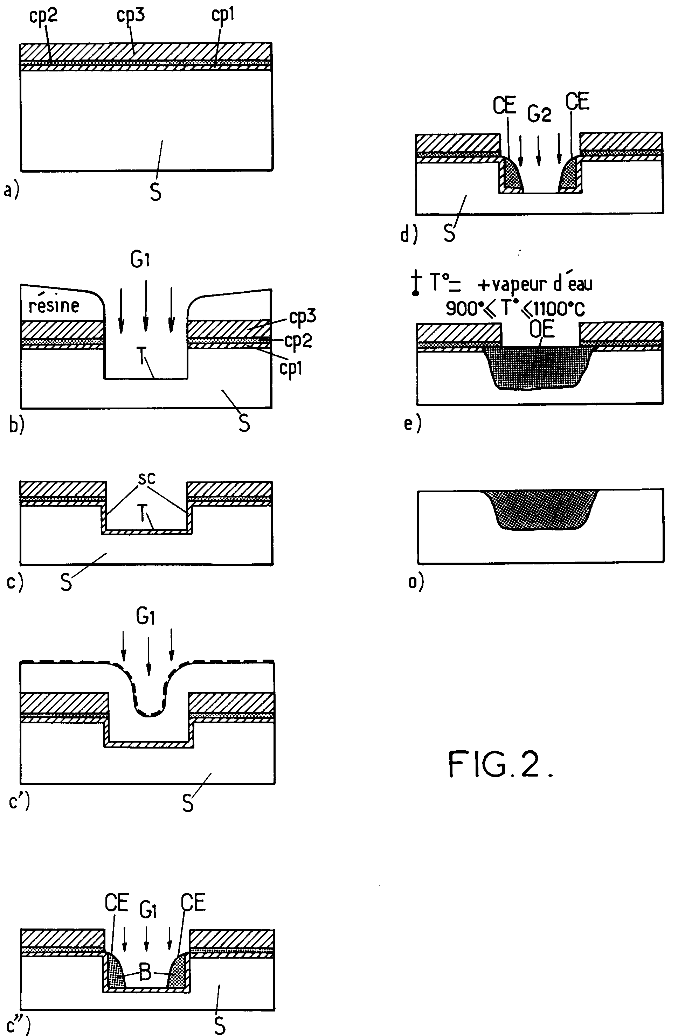

Une description plus détaillée du procédé d'oxydation localisée enterrée d'un substrat de silicium objet de la présente invention sera donnée en liaison avec la figure 2.

Ainsi qu'on l'a représenté sur cette figure, le procédé objet de la présente invention consiste successivement à effectuer, sur la surface libre du substrat de silicium, noté S, un scellement de cette surface par croissance d'une couche de nitrure de silicium formant au moins une couche superficielle.

Au point a) de la figure 2, on a représenté différentes couches superficielles notées cp1, cp2, cp3.

Les couches cp1, cp2, cp3 ont pour objet d'assurer le scellement de la surface libre du substrat de silicium S, cette surface libre formant interface horizontale.

De manière avantageuse, la première couche superficielle cp1 est formée par une première nitruration par croissance contrôlée, notamment en température et en présence d'ammoniac, sur la surface libre du substrat S d'une couche de nitrure de silicium, cette couche obtenue par diffusion dans les couches superficielles de silicium d'espèces azotées issues d'une atmopshère réactive étant une couche mince dont l'épaisseur n'excède pas 5 nm.

Bien entendu, le substrat de silicium S est, dans ce but, placé dans un four permettant éventuellement de créer un plasma d'ammoniac et soumis aux opérations classiques de traitement par ce type de four, lesquelles ne seront pas décrites en détails, ces opérations correspondant à des opérations de type classique.

De manière avantageuse, la couche cp2 est une couche de matériau piédestal, tel que par exemple l'oxyde de silicium $SiO_2$ ou de silicium polycristallin, cette couche pouvant être déposée par dépôt chimique en phase vapeur éventuellement assistée par plasma par exemple, une telle couche étant déposée sur une épaisseur de 10 à 25 nm.

La couche superficielle cp3 enfin est une couche de nitrure de silicium déposée en couche épaisse par un procédé de dépôt chimique en phase vapeur par exemple sur une épaisseur de 20 nm à 100 nm.

On comprendra ainsi que les couches cp1, cp2, cp3 forment, pour la surface libre du substrat S, un scellement particulièrement efficace permettant la poursuite de la mise en oeuvre du procédé selon l'invention.

Ce dernier consiste ensuite, ainsi que représenté notamment au point b) de la figure 2, à effectuer, suite à une étape de masquage appropriée, une gravure notée G1 dans le substrat de silicium S et dans la couche de nitrure de silicium obtenue par première nitruration notamment, afin de former une tranchée T destinée à recevoir l'oxydation localisée enterrée.

Sur le point b) de la figure 2, la gravure G1 est symbolisée par des flèches. On comprendra bien sûr que, préalablement au processus de gravure proprement dit, un processus de masquage au moyen d'une résine a été convenablement effectué afin de représenter, sur la surface libre du substrat S et, en particulier, sur les couches cp1, cp2, cp3 constituant le scellement, la forme bidimentionnelle de la tranchée T dans laquelle la couche d'oxyde enterrée devra être développée au cours de la mise en oeuvre ultérieure du procédé.

De manière non limitative, la gravure G1 est effectuée par un procédé anisotrope par gravure ionique réactive adaptée sur une profondeur de l'ordre de quelques centaines de nm à compter de l'interface substrat S/couche cp1 par exemple.

Suite à l'étape représentée au point b) de la figure 2, le procédé objet de la présente invention consiste, après retrait de la résine constituant le masque de gravure, à effectuer, ainsi que représenté au point c) de cette même figure 2, sur la surface libre de la tranchée T, une deuxième nitruration pour réaliser un scellement, noté sc, par croissance d'une couche de nitrure de silicium sur les parois de la tranchée T.

De manière avantageuse, cette deuxième nitruration peut être effectuée par un traitement du substrat S comportant la tranchée T, dans des conditions analogues à celles nécessaires à la mise en oeuvre de la première nitruration. En particulier, l'épaisseur de la couche de nitrure de silicium assurant le scellement sc est de l'ordre de 5nm.

Le procédé objet de la présente invention peut consister alors, ainsi que représenté au point d) de la figure 2, à effectuer, sur la paroi de fond de la tranchée T, une gravure notée G2, ou au moins une partie de la surface de cette paroi de fond, de la couche de nitrure de silicium obtenue par la deuxième nitruration précédemment décrite afin de découvrir le matériau du substrat de silicium.

La gravure G2 précitée est également symbolisée par des flèches verticales, de la même manière que la gravure G1, ces deux gravures pouvant avantageusement être réalisées au moyen de procédés de gravure ionique réactive adaptés engendrant une gravure anisotrope du substrat de silicium. Un processus plus détaillé de gravure de la paroi de fond de la tranchée et, en particulier, du scellement sc sur cette paroi, sera décrite ultérieurement dans la description.

Le procédé objet de la présente invention, tel que représenté en figure 2, consiste enfin à effectuer, ainsi qu'on l'a représenté au point 2 de cette même figure, une oxydation localisée du matériau, c'est-à-dire du silicium mis à nu en fond de tranchée T, pour réaliser l'oxydation enterrée notée OE du substrat dans la tranchée T.

Dans ce but, le substrat, tel qu'obtenu précédemment à la fin de l'étape du procédé tel que représenté au point d) de la figure 2, est alors placé dans un four en atmosphère humide, dont la température est comprise entre 900°C et 1100°C par exemple.

Au point o) de la figure 2, on a représenté le substrat obtenu après croissance de la couche d'oxyde enterrée OE, les couches superficielles cp1, cp2 et cp3 ayant été supprimées par gravure sélective par exemple.

On notera bien entendu qu'au cours de la mise en oeuvre du procédé tel que précédemment décrit en liaison avec la figure 2, la profondeur de la tranchée T et l'épaisseur de l'oxyde localisé OE détermine en fait la différence d'alignement entre la surface libre de l'oxyde enterré OE et celle du substrat de silicium S.

En tout état de cause, la surface libre de la couche d'oxyde de silicium enterrée OE est sensiblement plane et parallèle à celle du substrat de silicium S après suppression des couches cp1, cp2, cp3.

On notera que dans le mode de réalisation du procédé objet de l'invention, tel que représenté en figure 2, la gravure G1 permettant de réaliser la tranchée T est réalisée par un processus de gravure anisotrope de façon que la tranchée T présente des parois latérales sensiblement verticales, orthogonales à la paroi de fond de la tranchée.

Dans un tel cas, et afin de faciliter la mise en oeuvre de l'étape d) du procédé objet de l'invention et, en particulier, du processus de gravure G2 de la couche de scellement sc en fond de tranchée, le procédé objet de la présente invention peut en outre consister, préalablement à l'étape d) consistant à réaliser une gravure, au moins partielle, de la couche de nitrure de silicium obtenue par deuxième nitruration, à déposer, ainsi que représenté en c'), une couche épaisse CE d'oxyde de silicium représentée en traits mixtes recouvrant la couche cp3 et les parois et fonds de tranchée.

Une gravure partielle notée G'1 de la couche épaisse CE d'oxyde de silicium est alors effectuée pour découvrir une partie de la couche de nitrure de silicium obtenue sur la paroi de fond de la tranchée T par la mise en oeuvre de la deuxième nitruration à l'étape c) précédente de mise en oeuvre du procédé selon l'invention. De préférence, la gravure partielle G'1 est effectuée par gravure anisotrope, symbolisée par des flèches verticales, et a pour effet de maintenir, au voisinage des parois latérales de la tranchée T, un bourrelet d'oxyde B protégeant la couche de nitrure de silicium obtenue par la deuxième nitruration. Le résultat de la gravure G'1 est représenté en c") de la figure 2. En particulier, ce bourrelet protecteur B assure la protection, lors de la gravure G2, du scellement sc, d'une part, sur les parois verticales de la tranchée T et, d'autre part, sur au moins une partie de la paroi de fond de cette même couche de scellement sc.

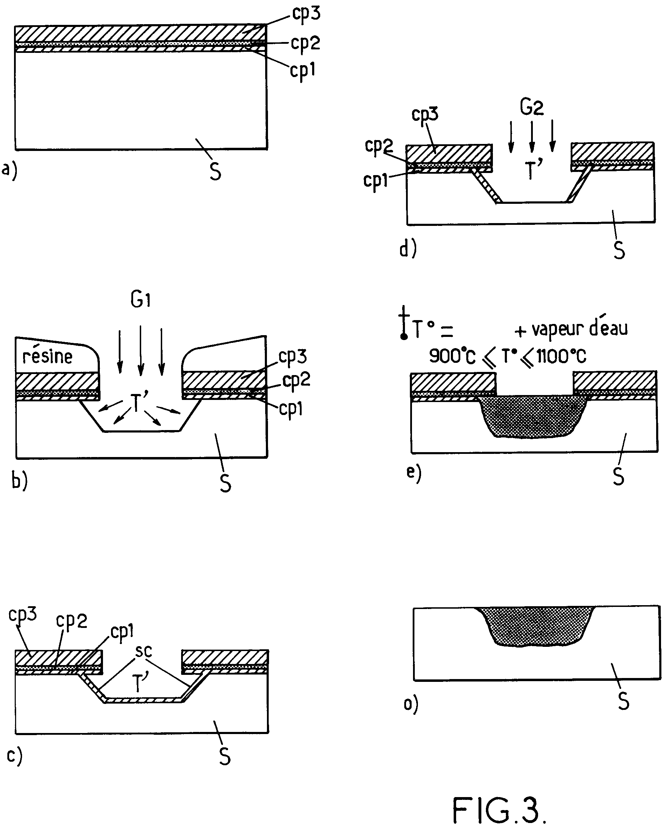

Toutefois, la mise en oeuvre d'un tel procédé nécessite l'étape supplémentaire c') de la figure 2, laquelle peut être supprimée par la mise en oeuvre du procédé objet de l'invention dans une deuxième variante de réalisation, une telle variante étant maintenant décrite en liaison avec la figure 3.

Dans la deuxième variante de réalisation telle que représentée sur la figure précitée, les points a), b), c), d) et e) correspondent, sensiblement, aux points portant les mêmes références de la figure 2.

Toutefois, ainsi qu'on pourra le remarquer à l'observation de la figure 3, le processus de gravure de la tranchée tel que représenté au point b) de la figure 3, est réalisé par une gravure semi-isotrope de façon à former une tranchée T' présentant des parois latérales sensiblement obliques par rapport à la paroi de fond de la tranchée.

Sur le point b) de la figure 3, on a représenté symboliquement la gravure G1 semi-isotrope par des flèches verticales prolongées par des flèches en arc de cercle.

Bien entendu, la gravure du substrat de silicium sous forme de gravure semi-isotrope est effectuée au moyen d'un procédé de gravure chimique liquide ou un procédé de gravure ionique réactive adaptée.

Ainsi qu'on pourra le remarquer à l'observation de la figure 3, la ou les couches superficielles cp1, cp2, cp3 forment vis-à-vis des parois latérales obliques de la tranchée T', un surplomb, ce surplomb ayant pour effet de protéger de la gravure les parties de la couche de nitrure de silicium formant le scellement sc, couche obtenue par deuxième nitruration, situées sur les parois latérales obliques précitées et sous ce surplomb.

Dans ce cas, et de manière identique au premier mode de réalisation représenté en figure 2, la gravure G2 est effectuée par une gravure anisotrope de façon à graver sensiblement la seule paroi de fond de la tranchée T' afin de supprimer le scellement sc sur cette paroi de fond.

De la même façon que dans le premier mode de réalisation représenté en figure 2, le substrat est ensuite soumis, au point e) de la figure 3, à une oxydation localisée du matériau pour réaliser l'oxydation enterrée, cette oxydation étant effectuée par oxydation thermique en atmosphère humide.

Enfin, au point o) de la figure 3, on a représenté le substrat de silicium S muni de sa couche d'oxyde enterrée OE après suppression des couches cp1, cp2, cp3.

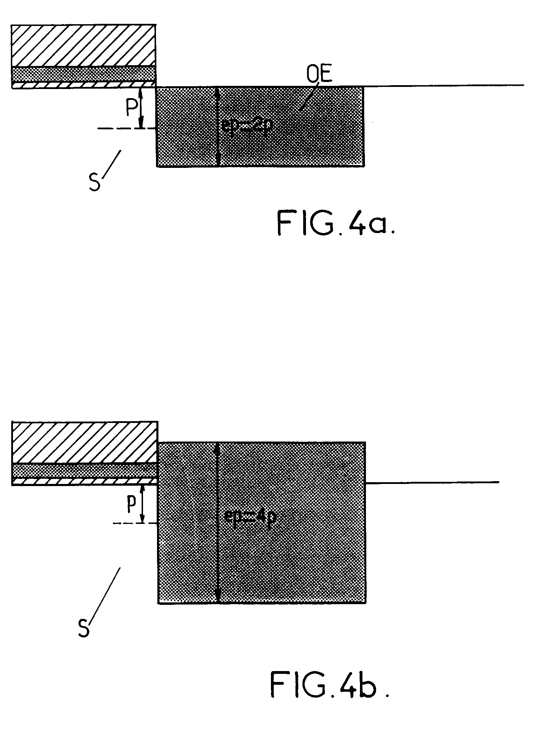

Sur les figures 4a et 4b, on a en outre représenté une plaquette de silicium S comportant au moins une couche d'oxyde de silicium enterrée OE avant suppression des couches cp1, cp, cp3.

Selon une caractéristique avantageuse de la plaquette ainsi obtenue, cette couche d'oxyde comporte une surface libre, plane et parallèle à la surface libre du substrat. On peut remarquer que la surface libre de l'oxyde peut être située au-dessus ou au-dessous de la surface libre de silicium suivant la profondeur p de la tranchée réalisée et suivant l'épaisseur de l'oxyde enterré OE réalisé. On a représenté en figure 4a le cas où ep est le double de p et en figure 4b, le cas où ep est égal à quatre fois p.

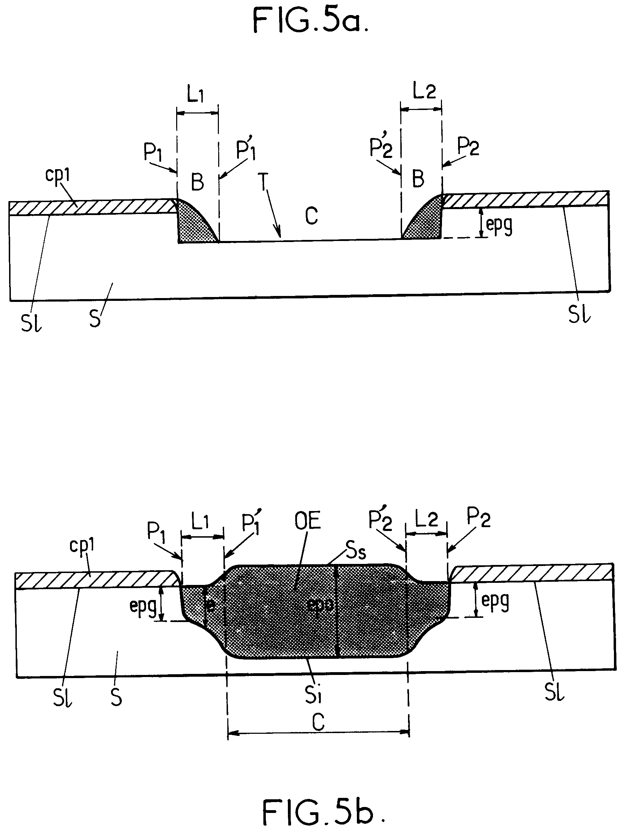

Une description plus détaillée d'un circuit intégré, conforme à l'objet de l'invention, et présentant une zone d'oxyde enterré réalisée selon le procédé objet de l'invention sera donnée en liaison avec les figures 5a et 5b.

Sur la figure 5a, on a représenté une vue cotée d'un substrat S de silicium soumis au procédé objet de l'invention et correspondant à l'étape d ) de la figure 2, soit après l'étape de gravure G2. Suite à cette étape la tranchée T délimitée par les plans p1, p2 transversaux à la surface libre S1 du substrat de silicium S comporte une zone centrale C entres les plans p'1, p'2 délimités par les bourrelets B d'oxyde de silicium.

A titre d'exemple non limitatif, les dimensions ci-après sont données à des fins purement illustratives. $p1p2 = 1,6 \ \mu m$, $p1p'1 = p2p'2 = 0,25 \ \mu m$, $epg = 0,05$ à $0,5 \ \mu m$;

epg désignant la profondeur de gravure de la tranchée T par rapport à la surface libre S1 du substrat S.

La figure 5b représente au contraire une vue en coupe dans le même plan de coupe que celui de la figure 5a, une vue cotée d'un circuit intégré objet de l'invention comportant une zone d'oxyde enterré réalisé selon le procédé de l'invention. Ainsi que représenté sur la figure précitée, le substrat S comporte au moins une zone d'oxyde enterré OE dans la tranchée T, laquelle est délimitée par des plans p1, p2 transversaux à la surface libre S1 du substrat. La zone d'oxyde enterré OE présente une épaisseur constante epo sur la partie centrale C, entre une surface supérieure Ss et une surface inférieure Si planes et parallèles à la surface libre S1 du substrat de silicium S. On notera que la partie centrale C correspond à la surface de fond de tranchée où la deuxième couche de nitrure a été gravée.

En outre et selon une caractéristique particulièrement avantageuse du circuit intégré selon l'invention tel que représenté en figure 5b, la zone d'oxyde enterré OE présente dans les zones latérales 11, 12 comprises entre la zone centrale C et les plans p1, p2 délimitant la tranchée T, soit entre les plans p1, p'1 respectivement p2, p'2, une épaisseur e variant de manière monotone entre la valeur de l'épaisseur de l'oxyde enterré dans la zone centrale epo et une valeur d'épaisseur epg, profondeur de gravure de la tranchée T dans le substrat de silicium S. En raison du fait que epg ≦ epo et compte tenu de la variation monotone de l'épaisseur e d'oxyde enterré dans les zones latérales précitées, on comprendra que la couche d'oxyde enterré OE au voisinage du bord de la tranchée T, c'est-à-dire dans les zones latérales précitées L1, L2, est exempte de tête d'oiseau.

A titre d'exemple purement illustratif la cote de l'épaisseur d'oxyde enterré en zone centrale C est prise égale à epo = 0,55 μm.

Enfin dans le mode de réalisation décrit en liaison avec la figure 5b, les plans p1 et p2, et par conséquent p'1 et p'2, sont sensiblement orthogonaux à la surface libre S1 du substrat de silicium S. La zone d'oxyde enterré OE à l'interface avec le substrat S au niveau des plans p1, p2 présente au voisinage à droite du plan p1, lors de l'observation de la figure 5b, une épaisseur égale à epg, profondeur de gravure de la tranchée T, et, respectivement, au voisinage à gauche du même plan p1, et en particulier sous le masque cp1, une épaisseur sensiblement nulle en l'absence de toute pénétration d'oxyde entre masque et surface libre du substrat, et réciproquement vis-à-vis des voisinages droite et gauche du plan p2. Compte tenu des caractéristiques des interfaces de l'oxyde enterré OE avec le substrat de silicium S, on comprendra que la ou les zones d'oxyde enterré OE sont également exemptes de bec d'oiseau.

On a ainsi décrit un procédé d'oxydation localisée enterrée d'un substrat de silicium particulièrement avantageux.

En effet, le processus de nitruration effectué par une croissance réactive contrôlée de la couche de nitrure correspondante, pour effectuer le scellement sc des parois de la tranchée T ou T', est tel que la couche de nitrure croissant à partir des surfaces de silicium est suffisamment efficace pour empêcher l'oxydation des surfaces de silicium correspondantes et suffisamment mince, inférieure ou égale à 5nm, afin d'éviter la création de contraintes mécaniques dans le silicium sous-jacent.

On notera en outre qu'en ajustant l'épaisseur de nitrure de silicium par rapport à l'épaisseur de l'oxyde enterré finale, il est d'autre part possible d'obtenir une oxydation progressive de la couche de nitrure de silicium, laquelle ne laisse aucun résidu en bord de masque de la structure enterrée (cf. figure 4a).

Pour la réalisation des couches de scellement obtenues par première et deuxième nitrurations, il est par exemple possible d'utiliser le procédé de nitruration assistée par plasma tel que décrit dans la demande de brevet français n° 83 18299 du 17 novembre 1983.

Des essais réalisés en laboratoire ont en effet montré qu'une plaquette de silicium recouverte d'une couche de nitrure de 5nm réalisée suivant le procédé précité, était susceptible de résister pendant une heure et demie à l'oxydation en vapeur d'eau, alors qu'une plaquette vierge de silicium placée dans les mêmes conditions était oxydée sur une épaisseur supérieure à 300nm.

On notera en outre que lors d'une exposition des couches de scellement sc à une durée supérieure au temps précité, celles-ci sont complètement transformées en oxyde.

En outre, la nitruration du silicium par une méthode de croissance telle que la nitruration assistée par plasma, permet d'obtenir des cinétiques de croissance fortement saturées, lesquelles autorisent le contrôle aisé de l'épaisseur finale de nitrure entre 2 et 6 nm pour constituer la couche de scellement sc. Il est donc ainsi possible d'ajuster sans difficulté l'épaisseur requise de nitrure en fonction de l'épaisseur finale de l'oxyde enterré désirée.

En outre, de manière semblable à toutes les méthodes de croissance, le processus de nitruration assistée par plasma donne lieu à une croissance isotrope de la couche de nitrure quelle que soit la géométrie des surfaces à nitrurer. Il est donc ainsi possible nitrurer, de manière uniforme, les surfaces de silicium des zones actives et celles correspondant aux parois de la tranchée. En outre, l'oxyde naturel présent à la surface des parois soumises au processus de nitruration précité est éliminé dès les premières étapes de la nitruration.

Une telle propriété assure la reproductibilité du procédé objet de la présente invention car l'oxyde naturel peut être différent d'une plaquette de silicium à l'autre.

Ainsi, le scellement obtenu est d'une très grande qualité, la couche de nitrure mince obtenue par première et deuxième nitrurations étant parfaitement adhérente sur le silicium et empêche l'oxydation latérale à la fois sous la couche de scellement sc et sous la couche mince de nitrure désignée par cp1 antérieurement dans la description, entre l'oxyde piédestal cp2 et la surface libre du substrat de silicium. L'oxydation de la paroi des tranchées T ou T′ est évitée limitant ainsi la production d'oxyde excédentaire et donc empêchant la formation de la tête d'oiseau.

L'oxydation latérale sous le masque, c'est-à-dire en fait sous les couches superficielles cp1, cp2, cp3, est évitée et il n'y a donc pas de formation de bec d'oiseau.

Cette dernière caractéristique apparaît également très importante car, dans une structure enterrée, le bec d'oiseau contribue également à la formation du renflement formant la tête d'oiseau. En effet, il a été démontré que la seule nitruration de la paroi de la tranchée T ou T′ n'était pas suffisante pour supprimer complètement le renflement précité.

C'est donc en effectuant un scellement continu et isotrope des surfaces horizontales, surfaces libres du substrat de silicium S, et verticales et/ou obliques, qu'il est possible de parvenir à l'obtention d'une couche d'oxyde enterré OE parfaitement uniforme et alignée sur la surface horizontale des zones actives.

## Revendications

1. Procédé d'oxydation localisée enterrée d'un substrat de silicium (S), caractérisé en ce qu'il consiste, successivement:
    – à effectuer a) sur la surface libre dudit substrat, par une première nitruration, un scellement par croissance contrôlée d'une couche de nitrure de silicium formant au moins une couche superficielle (cp1, cp2, cp3), afin d'assurer le scellement de ladite surface libre, formant interface horizontale, cette couche superficielle (cp1) étant obtenue par diffusion dans les couches superficielles de silicium d'espèces azotées d'une atmosphère réactive et présentant une épaisseur n'excédant pas 5 nm,
    – à effectuer b), suite à une étape de masquage appropriée, la gravure (G1), dans ledit substrat de silicium et ladite couche de nitrure de silicium, d'une tranchée (T) destinée à recevoir ladite oxydation localisée enterrée, la profondeur de la tranchée et l'épaisseur de l'oxyde localise déterminant la différence d'alignement entre la surface libre de l'oxyde enterré et celle du substrat de silicium (S),
    – à effectuer c) sur la surface libre de ladite tranchée, par une deuxième nitruration, un scellement (sc) par croissance d'une couche de nitrure de silicium, afin d'assurer le scellement des parois de ladite tranchée,
    – à effectuer d), sur au moins une partie des surfaces de fond de ladite tranchée, une gravure (G2), de la couche de nitrure de silicium obtenue par ladite deuxième nitruration, afin de découvrir le matériau dudit substrat de silicium,
    – à effectuer e) une oxydation localisée dudit matériau pour réaliser l'oxydation enterrée (OE) dudit substrat dans la tranchée.

2. Procédé selon la revendication 1, caractérisé en ce que, suite à l'étape consistant à effectuer ladite première nitruration et préalablement à l'étape de masquage et de gravure de la tranchée, ledit procédé consiste :
    – à effectuer sur ladite couche de nitrure de silicium (cp1) obtenue par la première nitruration, un dépôt d'une couche protectrice d'oxyde de silicium (cp2), ou de silicium polycristallin,
    – à effectuer sur ladite couche protectrice un dépôt d'une couche épaisse de nitrure de silicium (cp3) pour former sur la surface libre du substrat des couches superficielles correspondantes.

3. Procédé selon l'une des revendications 1 ou 2, caractérisé en ce que ledit processus de gravure de la tranchée est réalisé par une gravure anisotrope, de façon à former une tranchée (T) présentant des parois latérales sensiblement verticales, orthogonales à la paroi de fond de la tranchée .

4. Procédé selon la revendication 3, caractérisé en ce que préalablement à l'étape d) consistant à réaliser une gravure, au moins partielle, de la couche de nitrure de silicium obtenue par deuxième nitruration , celui-ci consiste :
    – à déposer c′) une couche épaisse (CE) d'oxyde de silicium, de façon à couvrir la totalité des surfaces où sont présentes les couches de nitrure de silicium, obtenues par ladite deuxième nitruration,
    – à effectuer une gravure (G′1), partielle, de ladite couche épaisse (CE) d'oxyde de silicium pour découvrir ladite couche de nitrure de silicium obtenue sur au moins une partie de la surface de fond de la tranchée par la deuxième nitruration, ladite gravure partielle (G′1) ayant pour effet de maintenir, au voisinage desdites parois latérales de la tranchée, un bourrelet (B) localement protecteur de ladite couche de nitrure de silicium obtenue par la deuxième nitruration.

5. Procédé selon l'une des revendications 1 ou 2, caractérisé en ce que ledit processus b) de gravure de la tranchée (T′) est réalisé par une gravure semi-isotrope, de façon à former une tranchée présentant des parois latérales sensiblement obliques par rapport à la paroi de fond de la tranchée, la où les couches superficielles (cp1, cp2, cp3) formant, vis-à-vis desdites parois latérales obliques, un surplomb protégeant de la gravure les parties de la deuxième couche mince de nitrure situées sous ce surplomb.

6. Procédé selon l'une des revendications précédentes, caractérisé en ce que ladite gravure (G2), sur au moins une partie de la surface de fond de ladite tranchée (T,T'), de la couche de nitrure de silicium obtenue par la deuxième nitruration est effectuée par une gravure anisotrope.

7. Procédé selon l'une des revendications précédentes, caractérisé en ce que ladite oxydation localisée e) du matériau pour réaliser l'oxydation enterrée du substrat dans la tranchée est effectuée par oxydation thermique en atmosphère humide.

8. Procédé selon l'une des revendications précédentes, caractérisé en ce que lesdites première et deuxième nitruration sont effectuées par nitruration sous plasma.

9. Circuit intégré sur substrat de silicium (S), caractérisé en ce que ledit substrat comporte au moins une zone d'oxyde enterré (OE) dans une tranchée (T) délimitée par des plans (p1, p2) transversaux à la surface libre (S1) du substrat (S), ladite zone d'oxyde enterré (OE) présentant une épaisseur constante (epo) sur une partie centrale (C), entre une surface supérieure (Ss) et une surface inférieure (Si) planes et parallèles à la surface libre (S1) du substrat de silicium.

10. Circuit intégré selon la revendication 9, caractérisé en ce que ladite zone d'oxyde enterré (OE) présente sur les zones latérales L1, L2 comprises entre la zone centrale (C) et lesdits plans (p1, p2) délimitant la tranchée, une épaisseur e variant de manière monotone entre la valeur de l'épaisseur de la zone centrale (epo) et une valeur d'épaisseur (epg) correspondant à la profondeur de gravure de la tranchée (T) dans le substrat de silicium (S), avec epg $\leqq$ epo.

11. Circuit intégré selon l'une des revendications 9 ou 10, caractérisé en ce que les plans p1 et p2 sont sensiblement orthogonaux à la surface libre du substrat (S), ladite zone d'oxyde à l'interface avec le substrat (S), au niveau desdits plans p1, p2, présentant au voisinage à droite du plan p1, une épaisseur égale à (epg), profondeur de gravure de la tranchée T, et, respectivement, au voisinage à gauche du même plan p1 une épaisseur sensiblement nulle et réciproquement vis-à-vis

du plan p2.

# FIG.1a.

tête d'oiseau

(1)

(3)

(4) bec d'oiseau

(1)

défaut dans
les zones actives

(2)

(2)

substrat

# FIG.1b.

tête d'oiseau

1er front

2eme front

FRONT D'OXYDATION

substrat

FIG.2.

10

FIG.3.

FIG.4a.

FIG.4b.

# FIG.5a.

# FIG.5b.

Office européen
des brevets

**RAPPORT DE RECHERCHE EUROPEENNE**

Numero de la demande

EP    92 40 0287
PAGE1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | FR-A-2 243 523 (N.V. PHILIPS GLOEILAMPENFABRIEKEN)<br>* page 1, ligne 1 - ligne 14 *<br>* page 1, ligne 33 - page 3, ligne 16 *<br>* page 6, ligne 2 - ligne 33; figures 1,2 *<br>* page 8, ligne 10 - page 10, ligne 25;<br>revendications 1-3,6-10; figures 5,8,9 * | 9,11 | H01L21/76<br>H01L21/32 |
| Y | | 1-8 | |
| Y | WO-A-9 100 615 (SGS-THOMSON MICROELECTRONICS S.A.)<br>* page 2, ligne 19 - page 3, ligne 7 *<br>* page 6, ligne 2 - page 7, ligne 12 *<br>* page 8, ligne 6 - page 10, ligne 21;<br>revendication 1; figures 3A-3F * | 1-8 | |
| Y | JAPANESE JOURNAL OF APPLIED PHYSICS, SUPPLEMENTS 18TH. CONF. ON SOLID STATE DEVICES AND MATERIALS 20 Août 1986, TOKYO JA<br>pages 295 - 298;<br>K.TSUKAMOTO ET AL.: 'Peripheral capacitor cell with fully recessed isolation for megabit DRAM'<br>* page 296, colonne de gauche; figure 2 * | 3,4 | |
| A | | 1,2,6,7,9 | H01L |
| X | PATENT ABSTRACTS OF JAPAN<br>vol. 10, no. 384 (E-466)23 Décembre 1986<br>& JP-A-61 174 737 ( OKI ELECTRIC IND CO LTD ) 6 Août 1986<br>* abrégé * | 9,10 | |
| Y | | 8 | |
| A | | 1,2,4-7 | |
| X | PATENT ABSTRACTS OF JAPAN<br>vol. 8, no. 88 (E-240)(1525) 21 Avril 1984<br>& JP-A-59 008 349 ( NIPPON DENKI K.K. ) 17 Janvier 1984<br>* abrégé * | 9,11 | |
| A | | 1,3,6-8 | |

DOMAINES TECHNIQUES RECHERCHES (Int. Cl.5)

Le présent rapport a été établi pour toutes les revendications

| Lieu de la recherche | Date d'achèvement de la recherche | Examinateur |
|---|---|---|
| BERLIN | 08 MAI 1992 | KLOPFENSTEIN P. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................
& : membre de la même famille, document correspondant

EPO FORM 1503 03.82 (P0402)

Office européen
des brevets

# RAPPORT DE RECHERCHE EUROPEENNE

Numero de la demande

EP    92 40 0287
PAGE2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| X | PATENT ABSTRACTS OF JAPAN<br>vol. 10, no. 209 (E-421)(2265) 22 Juillet 1986<br>& JP-A-61 048 936 ( MATSUSHITA ELECTRONICS CORP.<br>) 10 Mars 1986<br>* abrégé * | 9,10 | |
| A | | 1,5,6,11 | |
| X | IEEE ELECTRON DEVICES LETTERS<br>vol. EDL-2, no. 10, Octobre 1981, NEW YORK, USA<br>pages 244 - 247;<br>J. HUI ET AL.: 'Selective oxidation technologies<br>for high density MOS'<br>* page 244, colonne de droite; figure 1A;<br>tableau 1 * | 9,10 | |
| A | | 1,11 | |
| X | EXTENDED ABSTRACTS, SPRING MEETING, MONTREAL,<br>QUEBEC.<br>vol. 90-1, 6 Mai 1990, PRINCETON, NEW JERSEY US<br>pages 616 - 617;<br>S.S.LEE ET AL.: 'A novel CMOS isolation<br>technology using a consumable nitride seal<br>during field oxidation'<br>* le document en entier * | 9-11 | |
| A | | 1-3,6,7 | |
| X | ELECTRONIC DESIGN.<br>vol. 37, no. 24, 23 Novembre 1989, HASBROUCK<br>HEIGHTS, NEW JERSEY<br>page 29;<br>DAVE BURSKY: 'CMOS process breaks "Bird's beak"<br>barrier'<br>* le document en entier * | 9,11 | |
| A | | 10 | |
| X | EP-A-0 052 948 (MOTOROLA INC)<br>* page 6, ligne 7 - page 9, ligne 8;<br>revendications 1,4; figures 3A-3F * | 9 | |
| A | | 1,5-8 | |

DOMAINES TECHNIQUES
RECHERCHES (Int. Cl.5 )

Le présent rapport a été établi pour toutes les revendications

| Lieu de la recherche | Date d'achèvement de la recherche | Examinateur |
|---|---|---|
| BERLIN | 08 MAI 1992 | KLOPFENSTEIN P. |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
 
& : membre de la même famille, document correspondant

EPO FORM 1503 03.82 (P0402)

EP 0 498 717 A1

**Office européen des brevets**

# RAPPORT DE RECHERCHE EUROPEENNE

Numero de la demande

EP 92 40 0287
PAGE3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| | --- | | |
| A | JOURNAL OF THE ELECTROCHEMICAL SOCIETY. vol. 137, no. 8, Août 1990, MANCHESTER, NEW HAMPSHIRE US pages 2586 - 2588; V.K.DWIVEDI: 'A Bird's-Beak-free sealed interface local oxidation technology for submicron ultra-large-scale integrated circuits' * page 2586, colonne de droite; figures 1,3 * * page 2587, colonne de droite - page 2588, colonne de gauche * | 1-3,6-8 | |
| | --- | | |
| A | APPLIED PHYSICS LETTERS. vol. 50, no. 2, 12 Janvier 1987, NEW YORK US pages 89 - 91; PASCALE BERRUYER ET AL.: 'Nitrogen implantation for local inhibition of oxidation' * page 89; figure 4 * | 1,5-10 | |
| | ----- | | DOMAINES TECHNIQUES RECHERCHES (Int. Cl.5) |

Le présent rapport a été établi pour toutes les revendications

| Lieu de la recherche | Date d'achèvement de la recherche | Examinateur |
|---|---|---|
| BERLIN | 08 MAI 1992 | KLOPFENSTEIN P. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P0402)

16